# EUROPÄISCHE PATENTSCHRIFT

(11) **EP 2 751 835 B1**
(45) Veröffentlichungstag und Bekanntmachung des Hinweises auf die Patenterteilung: **24.01.2018**
(21) Anmeldenummer: 12748703.1
(22) Anmeldetag: 22.08.2012
(51) Int. Cl.: H01L 29/74, H01L 29/78, H01L 27/02

(54) **ESD-SCHUTZEINRICHTUNG ZUM SCHUTZ EINER IC-SCHALTUNG VOR NEGATIVEN ÜBERSPANNUNGEN**
ESD PROTECTION DEVICE FOR PROTECTING AN IC FROM NEGATIVE OVERVOLTAGE
DISPOSITIF DE PROTECTION ÉLECTROSTATIQUE POUR LA PROTECTION D'UN CIRCUIT INTÉGRÉ CONTRE LES SURTENSIONS NÉGATIVES

(30) Priorität: 29.08.2011 EP 11179178
(43) Veröffentlichungstag der Anmeldung: 09.07.2014
(73) Patentinhaber: Elmos Semiconductor Aktiengesellschaft, 44227 Dortmund (DE)
(72) Erfinder: FISCHER, Stephan, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2012/066304
(87) Internationale Veröffentlichungsnummer: WO 2013/030052

(56) Entgegenhaltungen:
- EP-A1- 1 130 652
- US-A- 6 137 140
- US-A1- 2006 043 487

## Beschreibung

Die Erfindung betrifft eine ESD-Schutzeinrichtung zum Schutz einer IC-Schaltung vor negativen Überspannungen an einem Anschlussfeld der IC-Schaltung und insbesondere an einem Kommunikationsbus-Anschlussfeld der IC-Schaltung.

IC-Schaltungen müssen gegen hohe transiente Ströme, wie sie beispielsweise im Falle elektrostatischer Entladungen (ESD) entstehen, geschützt sein. Dabei sollen derartige Ströme auch dann abgeleitet werden und die IC-Schaltung dementsprechend geschützt sein, wenn diese funktional für negative Spannungen ausgelegt sein müssen, wie dies beispielsweise bei Bus-Kommunikationssystemen (LIN, FlexRay, CAN) im sogenannten "loss of ground" Fall gegeben sein muss. Hierbei wird verlangt, dass die hohen transienten Ströme innerhalb der IC-Schaltung abgeleitet werden, ohne dass die dafür verwendete Schutzeinrichtung irreversible Schäden nimmt. Ferner sollen die auftretenden Spannungsdrops über diesen Schutzstrukturen so klein sein, dass keine der parallel angeschlossenen, funktionalen Bauelemente der IC-Schaltung oder deren isolierende Schichten geschädigt werden können. Gleichzeitig soll aber die Schutzeinrichtung die Funktion der zu schützenden IC-Schaltung innerhalb von dessen zulässigen Betriebsspannungsbereich (beispielsweise von -27 V bis +40 V) nicht beeinflussen.

Die Einhaltung der ESD-Anforderungen werden auf Chip-Ebene typischerweise mit ESD-Standardtests überprüft. Für Bus-Pins bzw. -Anschlussfelder von IC-Schaltungen werden besondere Testszenarien durchgeführt, bei denen mit einer System-Level-ESD-Pistole der zu schützende Anschluss-Pin direkt gegen die elektrische System-Masse belastet wird. Die dabei impulsförmig auftretenden Stromspitzen können dabei die typischen Chip-Level-Anforderungen um mehr als das 20-fache überschreiten.

Aus US-A-2006/0043487, US-A-6 137 140 und EP-A-1 130 652 sind jeweils als sogenannte Silicon-Controlled-Rectifier-(SCR-)Transistorstrukturen ausgebildete ESD-Schutzeinrichtungen bekannt, die eine Ringstruktur mit einem zentralen Source-Anschlussgebiet, ein sich ringförmig um dieses erstreckendes Gate-Kanalgebiet sowie ein wiederum um das Gate herum verlaufendes Drain-Anschlussgebiet aufweisen. Dabei sind die Drain-Anschlussgebiete aus mehreren längs der Halbleitersubstratoberfläche nebeneinander angeordneten, einander kontaktierenden n- und p-Dotierungsgebieten zusammengesetzt. Dadurch weisen die Transistoren parasitäre npnp-Tyristoren auf, die, wenn sie zünden, den zum Schutz einer IC-Schaltung von dieser fernzuhaltenden Strom vom zentralen Source-Anschlussgebiet lateral, d.h. längs bzw. unterhalb der Oberfläche zum Drain-Anschlussgebiet leiten.

Aufgabe der Erfindung ist es, eine ESD-Schutzeinrichtung zum Schutz einer IC-Schaltung vor negativen Überspannungen an einem Anschlussfeld der IC-Schaltung und insbesondere an einem Kommunikationsbus-Anschlussfeld der IC-Schaltung zu schaffen, die die zuvor genannten Anforderungen erfüllt.

Zur Lösung dieser Aufgabe wird mit der Erfindung eine ESD-Schutzeinrichtung zum Schutz einer IC-Schaltung vor negativen Überspannungen an einem Anschlussfeld der IC-Schaltung und insbesondere an einem Kommunikationsbus-Anschlussfeld der IC-Schaltung vorgeschlagen, die mit einem der IC-Schaltung vorgeschalteten und insbesondere parallel zur zu schützenden IC-Schaltung geschalteten ESD-Schutzbauteil für negative Überspannungen versehen ist, wobei dieses Schutzbauteil die Merkmale des Anspruchs 1 aufweist. Einzelne Ausgestaltungen der Erfindung sind Gegenstand der Unteransprüche.

Mit der Erfindung wird vorgeschlagen, einen bestimmten Typ von Transistor, der invers zu seinem Normalbetrieb eingesetzt wird, als ESD-Schutzbauteil für negative Überspannungen zu nutzen, wobei vornehmlich dessen parasitäre Elemente genutzt werden. Eine Variante dieses Transistortyps ist beispielhaft in DE-C-43 22 549 beschrieben.

Der erfindungsgemäß eingesetzte Transistor des ESD-Schutzbauteils ist in einem Halbleitersubstrat ausgebildet, das mit Ladungsträgern von einem ersten Leitungstyp (beispielsweise p-Leitungstyp) dotiert ist. Bei dem Halbleitersubstrat handelt es sich beispielsweise um schwach p-dotiertes Epitaxie-Silizium. Dieses Halbleitersubstrat weist eine Oberseite auf, innerhalb derer ein Aktivgebiet ausgebildet wird, das den Transistor darstellt und beispielsweise von sogenanntem Feld-Oxid umgeben ist. Innerhalb des Aktivgebiets weist das Halbleitersubstrat an seiner Oberseite eine erste Wanne auf, die durch Ionenimplantation mit Ladungsträgern von einem zweiten Leitungstyp (beispielsweise n-Leitungstyp) dotiert ist, welcher entgegengesetzt zum ersten Leitungstyp ist. Innerhalb dieser ersten Wanne ist in der Oberseite des Halbleitersubstrats ein Drain-Anschlussgebiet ausgebildet, was beispielsweise durch eine entartete Dotierung mit Ladungsträgern des zweiten Leitungstyps erfolgt.

Beabstandet zum Drain-Anschlussgebiet befindet sich innerhalb der ersten Wanne an der Oberseite des Halbleitersubstrats eine zweite Wanne, die durch Implantation mit Ladungsträgern vom ersten Leitungstyp entstanden ist. Innerhalb dieser zweiten Wanne befindet sich an der Oberseite des Halbleitersubstrats ein Source-Anschlussgebiet, das beispielsweise durch eine entartete Dotierung mit Ladungsträgern vom zweiten Leitungstyp ausgebildet ist. Zwischen dem Source-Anschlussgebiet und dem Drain-Anschlussgebiet befindet sich das Gate des Transistors, das eine Gate-Oxidschicht und eine darauf ausgebildete Gate-Elektrode aufweist. Das Gate grenzt an beide Anschlussgebiete an. Dabei ist die Gate-Oxidschicht zum Drain-Anschlussgebiet hin wesentlich dicker als zum Source-Anschlussgebiet hin.

Der zuvor beschriebene an sich bekannte Transistor ist nun erfindungsgemäß in spezieller Weise verschaltet. Erfindungsgemäß ist die Gate-Elektrode mit dem Source-Anschlussgebiet über einen Widerstand oder eine Diode verbunden, so dass die Gate-Elektrode eine steuernde Funktion ausübt. Zusätzlich weist die zweite Wanne noch ein (weiteres) Wannen-Anschlussgebiet auf, das durch eine entartete Dotierung mit Ladungsträgern des ersten Leitungstyps ausgebildet ist. Dieses Wannen-Anschlussgebiet liegt auf dem gleichen Potential wie das Source-Anschlussgebiet. Mit der Gate-Elektrode und den beiden zuvor genannten Anschlussgebieten ist nun das betreffende Anschlussfeld der zu schützenden IC-Schaltung elektrisch gekoppelt, was bedeutet, dass eine direkte elektrische Verbindung oder aber eine indirekte elektrische Verbindung (nämlich über zwischengeschaltete elektrische/elektronische Bauteile) gegeben ist.

Der erfindungsgemäße eingesetzte Transistor weist auf Grund seiner Struktur und Konstruktion eine parasitäre NPNP-Struktur auf, die nun erfindungsgemäß als ESD-Schutzeinrichtung benutzt wird. Dazu wird das ESD-Schutzbauteil mit seinem Source-Anschlussgebiet an das Pad (Anschlussfeld) des zu schützenden IC-Pins angeschlossen. Das Drain-Anschlussgebiet kann an ein beliebiges positives Potential (beispielsweise an eine positive ESD-Klemmung) angeschlossen sein. Damit leitet der erfindungsgemäß eingesetzte und verschaltete Transistor zwecks Schutzes der IC-Schaltung Ströme, die auf Grund hoher negativer (Substrat-)Spannungen, welche infolge von ESD-Effekten entstehen, statt lateral, d.h. entlang der Oberfläche des Substrats, vielmehr vertikal in dieses ab, was eine höhere Stromtragfähigkeit bedeutet.

Das erfindungsgemäße ESD-Schutzbauteil für negative Überspannungen kann in Kombination mit einer ESD-Schutzeinrichtung für positive Überspannungen kombiniert werden. Diese letztgenannte ESD-Schutzeinrichtung kann in verschiedenen Ausgestaltungen, die im Stand der Technik grundsätzlich bekannt sind, realisiert sein. Aus diesem Grund wird auf die ESD-Schutzeinrichtung für positive Überspannungen an dieser Stelle nicht weiter eingegangen.

Die Erfindung wird nachfolgend anhand eines Ausführungsbeispiels und unter Bezugnahme auf die Zeichnung näher erläutert. Im Einzelnen zeigen dabei:
- Fig. 1: schematisch ein Schaltbild mit einer zu schützenden IC-Schaltung, der ESD-Schutzeinrichtung und dem Anschlussfeld (Pad), an dem die ESD-Schutzeinrichtung angeschlossen ist,
- Fig. 2: eine Querschnittsdarstellung des Aufbaus des ESD-Schutzbauteils für negative Überspannungen mit schematisch dargestellten parasitären Bauteilen und
- Fig. 3: das Ersatzschaltbild des ESD-Schutzbauteils für negative Überspannungen, wenn dieses Schutzbauteil seine Schutzfunktion ausübt.

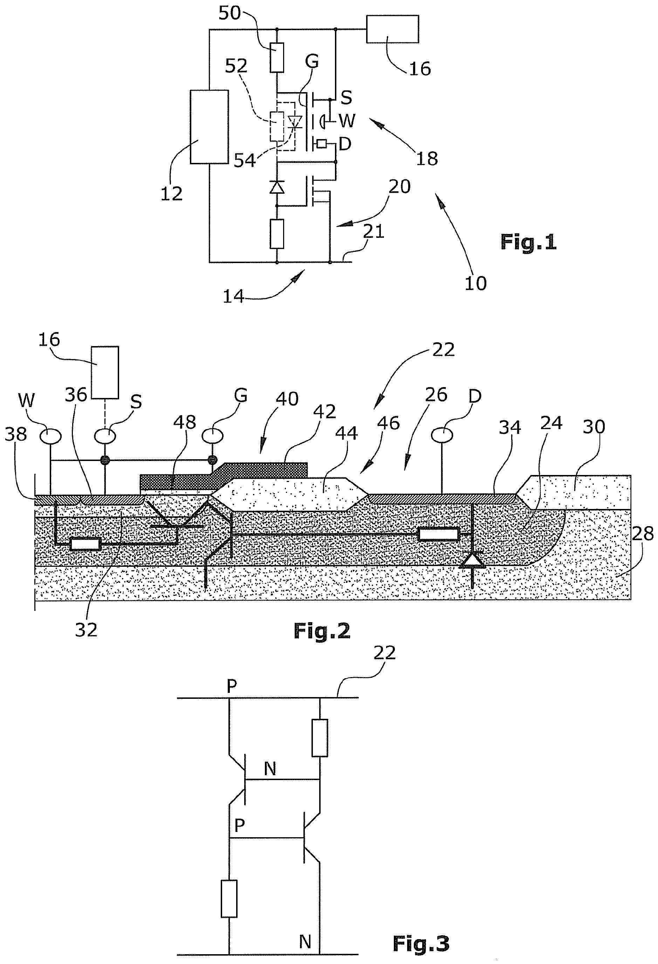

Fig. 1 zeigt schematisch ein Schaltbild 10, das eine zu schützende IC-Schaltung 12 (als Funktionsblock dargestellt), eine ESD-Schutzeinrichtung 14 sowie ein Anschlussfeld bzw. Pad 16 der IC-Schaltung 12 umfasst, an dem die ESD-Schutzeinrichtung 14 angeschlossen ist. In diesem Ausführungsbeispiel ist die ESD-Schutzeinrichtung 14 parallel zur zu schützenden IC-Schaltung 12 verschaltet. Die Schutzeinrichtung 14 umfasst ein Bauteil 18 für negative Überspannungen gemäß einem Ausführungsbeispiel nach der Erfindung sowie ein in Reihe mit diesem Bauteil 18 geschaltetes ESD-Schutzbauteil 20 für positive Überspannungen. Bei 21 ist in Fig. 1 derjenige Schaltungspunkt bezeichnet, an dem Substratpotential herrscht; in diesem Ausführungsbeispiel handelt es sich dabei um das Massepotential. Das Bauteil 18 ist als MOS-Transistor ausgebildet, der einen Drain-Anschluss D, einen Gate-Anschluss G, einen Source-Anschluss S und einen Substrat- bzw. Wannenanschluss W aufweist.

Anhand der Fign. 2 und 3 wird nachfolgend die Konstruktion und die Struktur des ESD-Schutzbauteils 18 für negative Überspannungen erläutert.

Gemäß Fig. 2 wird als ESD-Schutzbauteil ein spezieller Transistor 22 eingesetzt, der eine parasitäre NPNP-Struktur aufweist. Zu diesem Zweck ist der Transistor 22 in einer ersten n-dotierten (Hochvolt-)Wanne 24 ausgebildet, die in die Oberseite 26 eines schwach dotierten p-Silizium-Halbleitersubstrats 28 eingebracht ist. Die n-Wanne 24 ist von sogenanntem Feld-Oxid, d.h. von einer recht dicken Oxidschicht 30 umgeben.

Innerhalb der ersten Wanne 24 ist in der Oberseite 26 des Halbleitersubstrats 28 eine zweite Wanne 32 ausgebildet. Diese zweite Wanne 32 ist p-dotiert.

Der Transistor 22 weist ferner ein Drain-Anschlussgebiet 34 auf, das in der ersten Wanne 24 ausgebildet ist, sowie ein Source-Anschlussgebiet 36 auf, das innerhalb der zweiten Wanne 32 oberflächennah ausgebildet ist. Die zweite Wanne 32 ist mit einem weiteren Anschlussgebiet, nämlich einem Wannen-Anschlussgebiet 38 versehen.

Zwischen dem Source-Anschlussgebiet 36 und dem Drain-Anschlussgebiet 34 erstreckt sich das Gate 40 des Transistors 22, das eine Gate-Elektrode 42 aus beispielsweise polykristallinem Silizium und eine darunter angeordnete Gate-Oxidschicht 44 umfasst. Diese Gate-Oxidschicht 44 ist in einem ersten Abschnitt 46 deutlich dicker als in einem zweiten Abschnitt 48. Im zweiten Abschnitt 48, der sich über die Oberfläche des Halbleitersubstrats 28 im Bereich der zweiten Wanne 32 erstreckt, weist die Gate-Oxidschicht 44 eine für ein Transistor-Gate übliche Dicke auf, während die Gate-Oxidschicht 44 in ihrem ersten Abschnitt 46, der sich zwischen der zweiten Wanne 32 und dem Drain-Anschlussgebiet 34 erstreckt, im Wesentlichen die Dicke des Feld-Oxids 30 aufweist.

Der Transistor 22 kann so beschaltet sein, dass die Gate-Elektrode 42, das Source-Anschlussgebiet 36 und, sofern vorhanden, das Wannen-Anschlussgebiet 38 untereinander elektrisch verbunden sind, also auf einem gemeinsamen Potential liegen. An diesen drei Komponenten ist das Anschlussfeld bzw. das Pad 16 angeschlossen (siehe Fig. 1). Das Drain-Anschlussgebiet 34 ist mit der Schutzstruktur für positive Überspannungen (Schutzbauteil 20) verbunden. Beide Schutzbauteile 18 und 20 liegen in Reihe.

Die parasitären Komponenten des Transistors 22 sind in Fig. 2 durch entsprechende Schaltungssymbole wiedergegeben. Das Ersatzschaltbild des Transistors 22 in Funktion als Schutzbauteil ist in Fig. 3 gezeigt.

Anstatt einer direkten elektrischen Verbindung der Gate-Elektrode 42 mit dem Source-Anschlussgebiet 36 des Transistors 22 nach Fig. 2 ist zwischen Gate und Source auch ein Widerstand 50 geschaltet, wie es in Fig. 1 gezeigt ist. Damit lässt sich das Gate des Transistors 22 steuerbar gestalten. Ferner ist zwischen der Gate-Elektrode 42 und dem Drain-Anschlussgebiet 34 ein (weiterer) Widerstand 52 (z.B. wenn Leckströme tolerierbar sind), eine Diode 54 (für Leckstromunterbindung) oder ein anderes einen Spannungsabfall erzeugendes Bauteil geschaltet, was ebenfalls in Fig. 1 angedeutet ist.

### BEZUGSZEICHENLISTE

- 10: Schaltbild
- 12: IC-Schaltung
- 14: ESD-Schutzeinrichtung für die IC-Schaltung
- 16: Pad
- 18: ESD-Schutzbauteil
- 20: ESD-Schutzbauteil
- 21: Substratpotential
- 22: Transistor
- 24: n-dotierte Wanne
- 26: Oberseite des Halbleitersubstrats
- 28: Halbleitersubstrat
- 30: Feld-Oxidschicht
- 32: zweite Wanne
- 34: Drain-Anschlussgebiet
- 36: Source-Anschlussgebiet
- 38: Wannen-Anschlussgebiet
- 40: Gate
- 42: Gate-Elektrode
- 44: Gate-Oxidschicht
- 46: erster Abschnitt der Gate-Oxidschicht
- 48: zweiter Abschnitt der Gate-Oxidschicht
- 50: Widerstand
- 52: Widerstand
- 54: Diode

## Patentansprüche

1. ESD-Schutzeinrichtung zum Schutz einer IC-Schaltung vor negativen Überspannungen an einem Anschlussfeld der IC-Schaltung und insbesondere an einem Kommunikationsbus-Anschlussfeld der IC-Schaltung, mit
- einem der IC-Schaltung (12) vorgeschalteten und insbesondere parallel zur zu schützenden IC-Schaltung (12) geschalteten ESD-Schutzbauteil (18) für negative Überspannungen, das aufweist
- ein Halbleitersubstrat (28), das mit Ladungsträgern von einem ersten Leitungstyp dotiert ist,
- eine durch Ionenimplantation in eine Oberseite (26) des Halbleitersubstrats (28) eingebrachte erste Wanne (24), die mit Ladungsträgern von einem bezogen auf den ersten Leitungstyp entgegengesetzten zweiten Leitungstyp dotiert ist,
- ein innerhalb der Flächenausdehnung der ersten Wanne (24) in der Oberseite (26) des Halbleitersubstrats (28) ausgebildetes Drain-Anschlussgebiet (34),
- eine von dem Drain-Anschlussgebiet (34) beabstandete und innerhalb der Flächenausdehnung der ersten Wanne (24) in der Oberseite (26) des Halbleitersubstrats (28) ausgebildete zweite Wanne (32), die mit Ladungsträgern vom ersten Leitungstyp dotiert ist,
- ein innerhalb der Flächenausdehnung der zweiten Wanne (32) in der Oberseite (26) des Halbleitersubstrats (28) ausgebildetes Source-Anschlussgebiet (36),
- eine Gate-Oxidschicht (44) mit einer auf dieser ausgebildeten Gate-Elektrode (42), wobei sich die Gate-Oxidschicht (44) jeweils an einander zugewandte Enden der Drain- und Source-Anschlussgebiete (34,36) angrenzend zwischen beiden Gebieten erstreckt und wobei die Gate-Oxidschicht (44) in ihrem sich ausgehend von dem Drain-Anschlussgebiet (34) auf der ersten Wanne (24) erstreckenden ersten Abschnitt (46) eine größere Dicke aufweist als in ihrem sich an den ersten Abschnitt (46) anschließenden, auf der zweiten Wanne (32) bis zum Source-Anschlussgebiet (36) verlaufenden zweiten Abschnitt (48), und
- ein Wannen-Anschlussgebiet (38) in der zweiten Wanne (32),
- wobei das Source-Anschlussgebiet (36) und das Wannen-Anschlussgebiet (38) ein gemeinsames elektrisches Potential aufweisen und elektrisch mit dem Anschlussfeld der zu schützenden IC-Schaltung (12) gekoppelt sind,
**dadurch gekennzeichnet,**
- **dass** das Drain-Anschlussgebiet (34) ausschließlich mit Ladungsträgern vom zweiten Leitungstyp dotiert ist,
- **dass** zwischen dem Source-Anschlussgebiet (36) und dem Wannen-Anschlussgebiet (38) einerseits und der Gate-Elektrode (42) andererseits ein Widerstand (50) geschaltet ist und
- **dass** zwischen der Gate-Elektrode (42) und dem Drain-Anschlussgebiet (34) ein Widerstand (52), eine Diode (54) oder ein anderes einen Spannungsabfall erzeugendes Bauelement geschaltet ist.

2. ESD-Schutzeinrichtung nach Anspruch 1, **dadurch gekennzeichnet, dass** die Gate-Elektrode (42) das gleiche Potential wie das Source-Anschlussgebiet (36) und das Wannen-Anschlussgebiet (38) aufweist.

3. ESD-Schutzeinrichtung nach Anspruch 1 oder 2, **dadurch gekennzeichnet, dass** zwischen dem Source-Anschlussgebiet (36) und dem Wannen-Anschlussgebiet (38) einerseits und dem Anschlussfeld (16) der zu schützenden IC-Schaltung (12) ein Widerstand geschaltet ist.

4. ESD-Schutzeinrichtung nach einem der Ansprüche 1 bis 3, **dadurch gekennzeichnet, dass** in Reihe mit dem ESD-Schutzbauteil (18) für negative Überspannungen ein weiteres ESD-Schutzbauteil (20) zum Schutz vor positiven Überspannungen geschaltet ist.

5. ESD-Schutzeinrichtung nach einem der Ansprüche 1 bis 4, **dadurch gekennzeichnet, dass** der erste Leitungstyp der p-Leitungstyp und der zweite Leitungstyp der n-Leitungstyp ist.

## Claims

1. ESD protection device for protecting an IC circuit from negative overvoltage at a connection field of the IC circuit and in particular at a communication bus connection field of the IC circuit, comprising
- an ESD protection component (18) for negative overvoltage, which is connected upstream of the IC circuit (12) and in particular connected in parallel to the IC circuit (12) to be protected, and which comprises
- a semiconductor substrate (28) which is doped with charge carriers of a first conduction type,
- a first trough (24) which is introduced by ion implantation into an upper side (26) of the semiconductor substrate (28), and which is doped with charge carriers having a second conduction type which is opposite relative to the first conduction type,
- a drain connection region (34) which is formed within the surface extent of the first trough (24) in the upper side (26) of the semiconductor substrate (28),
- a second trough (32) spaced from the drain connection field (34) and formed within the surface extent of the first trough (24) in the upper side (26) of the semiconductor substrate (28), the second trough (32) being doped with charge carriers of the first conduction type,
- a source connection region (36) formed within the surface extent of the second trough (32) in the upper side (26) of the semiconductor substrate (28),
- a gate oxide layer (44) with a gate electrode (42) formed thereon, wherein the gate oxide layer (44) extends between the drain and source connection regions (34, 36) and respectively adjoining the facing ends of both regions, and wherein the gate oxide layer (44) has a greater thickness in its first section (46) extending on the first trough (24) from the drain connection region (34) than in its second section (48) adjoining the first section (46) and extending on the second trough (32) to the source connection region (36), and
- a trough connection region (38) in the second trough (32),
- wherein the source connection region (36) and the trough connection region (38) have a common electric potential and are electrically coupled with the connection field of the IC circuit (12) to be protected, and
**characterized in**
- **that** the drain connection region (34) is doped exclusively with charge carriers of the second conduction type,
- **that** a resistor (50) is connected between the source connection region (36) and the trough connection region (38) on the one hand and the gate electrode (42) on the other hand, and
- **that** a resistor (52), a diode (54) or another component causing a voltage drop is connected between the gate electrode (42) and the drain connection region (34).

2. ESD protection device of claim 1, **characterized in that** the gate electrode (42) has the same potential as the source connection region (36) and the trough connection region (38).

3. ESD protection device of claim 1 or 2, **characterized in that** a resistor is connected between the source connection region (36) and the trough connection region (38) on the one hand and the connection field (16) of the IC circuit (12) to be protected on the other hand.

4. ESD protection device of one of claims 1 to 3, **characterized in that** a further ESD protection component (20), provided for protection from positive overvoltage, is connected in series with the ESD protection component (18) for protection from negative overvoltage.

5. ESD protection device of one of claims 1 to 4, **characterized in that** the first conduction type is the p-conduction type and the second conduction type is the n-conduction type.

## Revendications

1. Dispositif de protection ESD pour protéger un circuit intégré des surtensions négatives sur un panneau de connexion du circuit intégré et en particulier sur un panneau de connexion du bus de communication du circuit intégré, avec
- un composant de protection ESD (18) raccordé au circuit intégré (12) et particulièrement en parallèle par rapport au circuit intégré (12) à protéger, comprenant
- un substrat semi-conducteur (28), dopé par des porteurs de charge d'un premier type de conductivité,
- une première cuvette (24) créée dans une face supérieure (26) du substrat semi-conducteur (28) par implantation ionique, dopée par des porteurs de charge d'un second type de conductivité opposé au premier type de conductivité choisi,
- une région de drain (34) formée à la surface de la première cuvette (24) dans la face supérieure (26) du substrat semi-conducteur (28),
- une seconde cuvette (32) formée à la surface de la première cuvette (24) dans la face supérieure (26) du substrat semi-conducteur (28) et espacée de la région de drain (34), dopée par des porteurs de charge du premier type de conductivité,
- une région de source (36) formée au sein d'une zone de surface de la première cuvette (24) dans la face supérieure (26) du substrat semi-conducteur (28),
- une couche d'oxyde de grille (44) avec une électrode de grille (42) du même matériau, dans laquelle la couche d'oxyde de grille (44) s'étend de manière adjacente entre les deux zones, respectivement aux deux extrémités se faisant face de la région de source (36) et de la région de drain (34), et dans laquelle la couche d'oxyde de grille (44) comporte, dans sa première section (46) s'étendant sur la première cuvette (24) à partir de la région de drain (34), une plus grande épaisseur que dans sa seconde section (48), qui se raccorde à la première section (46) et va sur la seconde cuvette (32) jusqu'à la région de source (36), et
- une région de cuvette (38) dans la seconde cuvette (32),
- dans laquelle la région de source (36) et la région de cuvette (38) présentent un potentiel électrique partagé et sont raccordées électriquement avec le panneau de connexion du circuit intégré à protéger (12), **caractérisé en ce que**
- la région de drain (34) est dopée exclusivement avec des porteurs de charges du second type de conductivité,
- une résistance (50) est disposée entre la région de source (36) et la région de cuvette (38) d'une part et l'électrode de grille (42) d'autre part et
- une résistance (52), une diode (54) ou un autre composant produisant une baisse de tension est disposé entre l'électrode de grille (42) et la région de drain (34).

2. Dispositif de protection ESD selon la revendication 1, **caractérisé en ce que** l'électrode de grille (42) présente le même potentiel que la région de source (36) et la région de cuvette (38).

3. Dispositif de protection ESD selon la revendication 1 ou 2, **caractérisé en ce qu'**une résistance est disposée entre la région de source (36) et la région de cuvette (38) d'une part et le panneau de connexion (16) du circuit intégré à protéger (12) d'autre part.

4. Dispositif de protection ESD selon une des revendications 1 à 3, **caractérisé en ce qu'**un composant de protection ESD supplémentaire (20) est disposé en série par rapport au composant de protection ESD (18) pour les surtensions négatives, afin de protéger contre les surtensions positives.

5. Dispositif de protection ESD selon une des revendications 1 à 4, **caractérisé en ce que** le premier type de conductivité est le type P et le second type est le type n.
